# EUROPÄISCHE PATENTSCHRIFT

(11) **EP 1 031 042 B1**
(45) Veröffentlichungstag und Bekanntmachung des Hinweises auf die Patenterteilung: **20.06.2001**
(21) Anmeldenummer: 99923454.5
(22) Anmeldetag: 16.04.1999
(51) Int. Cl.: G01R 31/28

(54) **VORRICHTUNG ZUM PRÜFEN VON LEITERPLATTEN**
DEVICE FOR TESTING PRINTED BOARDS
DISPOSITIF POUR VERIFIER DES CARTES DE CIRCUITS

(30) Priorität: 02.11.1998 DE 19850367
(43) Veröffentlichungstag der Anmeldung: 30.08.2000
(73) Patentinhaber: ATG TEST SYSTEMS GmbH & Co. KG, 97877 Wertheim (DE)
(72) Erfinder: PROKOPP, Manfred, D-97877 Wertheim-Reicholzheim (DE)
(74) Vertreter: Ganahl, Bernhard
(86) Internationale Anmeldenummer: EP9902753
(87) Internationale Veröffentlichungsnummer: WO0026681

(56) Entgegenhaltungen:
- EP-A- 0 838 688
- VANDERHELM R: "SMART TESTER FOR FLEX INTERFACE" MOTOROLA TECHNICAL DEVELOPMENTS, Bd. 19, 1. Juni 1993 (1993-06-01), Seiten 88-90, XP000361490
- T. H. NEWSOM ET AL.: "card test flexibility with reduced lead length" IBM TDB, Bd. 23, Nr. 7b, Dezember 1980 (1980-12), Seiten 3096-3097, XP002113173

## Beschreibung

Die Erfindung betrifft eine Vorrichtung zum Prüfen von Leiterplatten.

Es wird von einem Stand der Technik gemäß der EP 838 688 A2 ausgegangen, die auf die Anmelderin der vorliegenden Patentanmeldung zurückgeht. Demgemäß wird eine Prüfvorrichtung vorgesehen, die eine Anzahl von Testanschlüssen aufweist, wobei Leiterplattentestpunkte der zu testenden Leiterplatte mit einem Testanschluß über eine elektrische Verbindung in Kontakt stehen.

Die Auswerteelektronik ist elektrisch mit einem Grundraster verbunden, wobei auf dem Grundraster ein Adapter und/oder ein Translator lagert, auf welche eine zu testende Leiterplatte aufgelegt werden kann. Der Adapter und/oder Translator stellt einen elektrischen Kontakt von auf der Leiterplatte befindlichen Leiterplattentestpunkten zu Kontaktstellen des Grundrasters her.

Diese Prüfvorrichtung zeichnet sich dadurch aus, daß zumindest zwei Kontaktstellen elektrisch miteinander verbunden sind. Insbesondere sind bei dieser Vorrichtung jeweils mehrere Kontaktstellen entlang je einem geradlinigen Scankanal elektrisch miteinander verbunden. Die einzelnen Scankanäle sind mit einer Auswerteelektronik elektrisch verbunden. Da jeder Scankanal mit mehreren Kontaktstellen verbunden ist, ist die Anzahl der Einheiten der Auswerteelektronik im Vergleich zu der Auswerteelektronik einer vergleichbaren Prüfvorrichtung erheblich vermindert und der gesamte Aufbau der Prüfvorrichtung gestaltet sich sehr einfach.

Obwohl bei dieser Prüfvorrichtung mehrere Testpunkte mit einem einzigen Scankanal elektrisch verbunden sind, hat sich überraschenderweise gezeigt, daß bei den allermeisten Anwendungen keine Doppelbelegungen der Scankanäle vorliegen bzw. derartige Doppelbelegungen mit einer gezielten Zuordnung der Leiterplattentestpunkte zu den Kontaktstellen der Prüfvorrichtung ausgeschlossen werden können. Dies wird dadurch erzielt, daß mit dieser bekannten Vorrichtung mit vergleichbar einfachen technischem Aufwand eine hohe Dichte an Kontaktstellen geschaffen wird. So wird ein mittlerer Abstand von 800 µm oder weniger zwischen benachbarten Kontaktstellen gefordert. Diese hohe Kontaktstellendichte ist vorteilhaft, da sie erlaubt, daß lokal eine entsprechend hohe Leiterplattentestpunktdichte kontaktiert werden kann, wobei gleichzeitig durch die Kontaktstellendichte eine ausreichende Redundanz zur Verfügung gestellt wird, so daß eine Doppelbelegung eines Scankanals sicher vermieden werden kann.

Mit der vorliegenden Erfindung soll eine einfache und kostengünstige Prüfvorrichtung zum Prüfen von großflächigen Leiterplatten geschaffen werden. Solche großflächigen Leiterplatten sind z.B. sogenannte "Backplanes", die eine Kantenlänge von z.B. 1000 mm x 750 mm besitzen. Großflächige Leiterplatten im Sinne der Erfindung sind Leiterplatten mit einer Kantenlänge von zumindest 500 mm x 500 mm bzw. einer Fläche von 250.000 mm².

Die Erfindung wird durch eine Prüfvorrichtung mit den Merkmalen des Anspruchs 1 gelöst. Vorteilhafte Ausgestaltungen sind in den Unteransprüchen angegeben.

Die Erfindung wird nachfolgend beispielhaft anhand der Zeichnungen näher erläutert. Es zeigen schematisch:
- Fig. 1: einen Bereich einer Grundrasterplatte im Schnitt quer zu den Scankanälen,
- Fig. 2: schematisch grob vereinfacht die Anordnung mehrerer Scankanäle und eine mehrere Scankanäle miteinander verbindende Busplatte, und

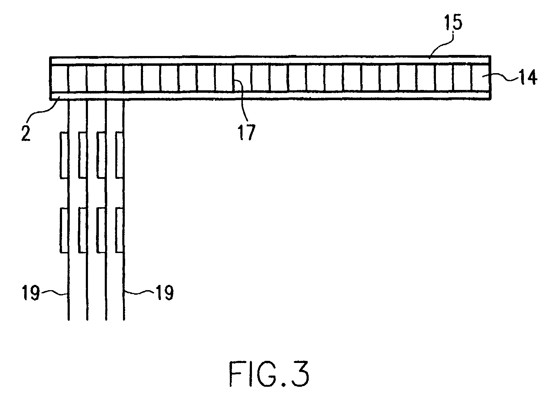

- Fig. 3: die in Fig. 2 gezeigte Anordnung in der Frontansicht (mit Blickrichtung gemäß dem Pfeil A in Fig. 2).

Die erfindungsgemäße Prüfvorrichtung 1 weist eine Grundrasterplatte 2 mit einem an ihrer Oberseite angeordneten Grundraster 3 auf, das aus einer Vielzahl in einem regelmäßigen Raster angeordneten, elektrisch leitenden Kontaktstellen 4 ausgebildet ist.

Die Grundrasterplatte 2 ist vorzugsweise aus einer laminierten Leiterplatte ausgebildet.

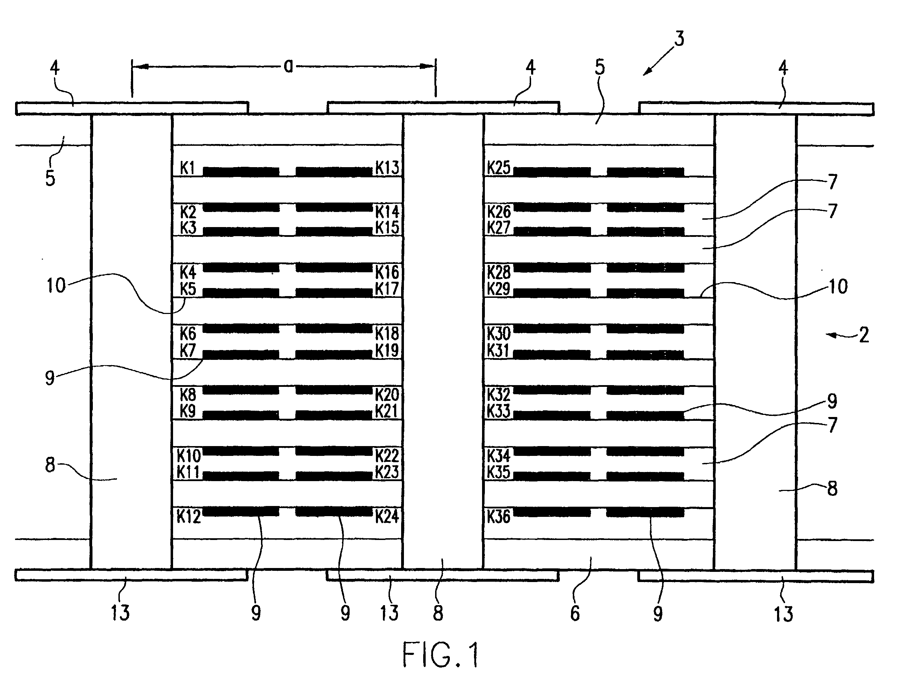

Das in Fig. 1 dargestellte Ausführungsbeispiel weist eine obere und eine untere Begrenzungslage 5, 6 und dreizehn Zwischenlagen 7 auf.

Von den Kontaktstellen 4 erstreckt sich senkrecht durch die oberste Lage 5 und alle Zwischenlagen 7 jeweils eine vertikale Durchkontaktierung 8. Die Durchkontaktierungen 8 sind in der Regel als Bohrungen mit einer leitenden, metallischen Beschichtung ausgebildet. Die Durchkontaktierungen 8 und damit die Kontaktstellen 2 sind bspw. in einem regelmäßigen quadratischen Raster, dem Grundraster, mit einem Mittenabstand a von z.B. 1,27 mm angeordnet. Es sind auch andere Arten einer regelmäßigen Rasterung möglich.

Die Durchkontaktierungen 8 und damit die Kontaktstellen 2 sind somit in Reihen angeordnet. Zwischen zwei Reihen von Durchkontaktierungen 8 sind jeweils Leiterbahnen 9 in der Grundrasterplatte 2 eingebettet, die nachfolgend als Scankanäle bezeichnet werden.

Bei dem in Fig. 1 gezeigten Ausführungsbeispiel sind zwischen zwei Reihen von Durchkontaktierungen 8 jeweils zwölf Scankanäle vorgesehen, die jeweils paarweise in einer Zwischenschicht zwischen zwei Zwischenlagen 7 angeordnet sind. Die jeweils zwölf Paare benachbart zu einer Reihe von Durchkontaktierungen 8 angeordneten Scankanäle 9 sind dieser Reihe zugeordnet, d.h., daß jede Durchkontaktierung 8 und damit jede Kontaktstelle 4 einer bestimmten Reihe elektrisch mit einem der dieser Reihe zugeordneten Scankanäle 9 über eine Stichleitung 10 verbunden ist. Bei dem vorliegenden Ausführungsbeispiel ist jede 24. Kontaktstelle 4 in einer Reihe jeweils mit dem gleichen Scankanal 9 elektrisch verbunden.

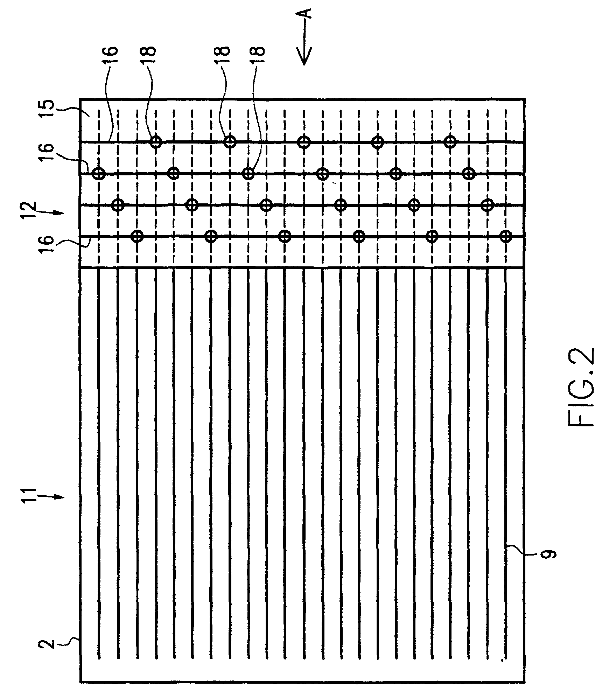

Fig. 2 zeigt eine Draufsicht auf die erfindungsgemäße Grundrasterplatte 2, wobei das Grundraster grob vereinfacht durch den Verlauf der Scankanäle 9 ohne Kontaktstellen 4 dargestellt ist. Zur Vereinfachung der zeichnerischen Darstellung sind lediglich wenige parallel in einer Ebene liegende Scankanäle 9 gezeigt.

Die Grundrasterplatte 2 weist einen, im dargestellten Ausführungsbeispiel etwa quadratischen Prüffeldbereich 11 und einen sich über den Prüffeldbereich 11 hinaus erstreckenden Anschlußbereich 12 auf. Am Anschlußbereich 12 sind wie beim Prüffeldbereich 11 an der Oberseite die in Fig. 1 gezeigten Kontaktstellen 4 als auch zusätzlich an der Unterseite Kontaktstellen 13 vorgesehen, die jeweils mittels der Durchkontaktierungen 8 und den Stichleitungen 10 mit den Scankanälen 9 elektrisch verbunden sind. Unmittelbar auf der Oberseite liegt ein Busadapter 14 auf, auf dem wiederum eine Busplatte 15 angeordnet ist. Die Busplatte 15 weist quer zu den Scankanälen 9 verlaufende, parallele Busleitungen 16 auf. Die Busleitungen 16 sind entweder auf der zum Busadapter 14 weisenden Oberfläche der Busplatte 15 offen liegend angeordnet oder in dem Abstand der Reihen von Durchkontaktierungen 8 mit an der Oberfläche der Busplatte 15 angeordneten Kontaktstellen elektrisch verbunden.

Der Busadapter 14 weist eine Vielzahl von Kontaktstiften 17 auf, die jeweils einen Scankanal 9 mit einer Busleitung 16 elektrisch verbinden. Die durch einen Kontaktstift 17 elektrisch verbundenen Kreuzungspunkte der Scankanäle 9 mit den Busleitungen 16 sind in Fig. 2 jeweils durch einen Kreis 18 gezeigt. Die Kontaktstifte 17 sind vorzugsweise als federnde Kontaktstifte ausgebildet.

Durch das Vorsehen des Busadapters 14 und der Busplatte 15 sind jeweils mehrere Scankanäle 9 über die Busleitungen 16 elektrisch miteinander verbunden.

Jede Gruppe von elektrisch miteinander verbundenen Scankanälen 9 ist mit einer Elektronikkarte 19 der Auswerteelektronik elektrisch verbunden, d.h., daß für mehrere Scankanäle lediglich ein einziger Anschluß zur Auswerteelektronik vorgesehen ist.

Hierdurch vermindert sich die Anzahl der Einheiten der Auswerteelektronik im Vergleich zu herkömmlichen Prüfvorrichtungen mit gleicher Kontaktstellenzahl drastisch, da die herkömmlichen Prüfvorrichtungen für jede Kontaktstelle einen separaten Anschluß und damit dem Anschluß zugeordnete Verarbeitungskapazität an Auswerteelektronik besitzt.

Die Elektronikkarten sind z.B. mittels einer Flexleitung und Federstiften, wie es aus der DE 196 27 801 C1 bekannt ist, elektrisch und mechanisch mit der Grundrasterplatte verbunden.

Durch die Erfindung sind nicht nur entlang eines geradlinigen Scankanals angeordnete Kontaktstellen, sondern auch über die Fläche der Grundrasterplatte verteilt angeordnete Kontaktstellen elektrisch verbunden.

Simulationen haben gezeigt, daß bei großflächigen Leiterplatten, wie z.B. Backplanes, die Mehrzahl der auf der Grundrasterplatte vorgesehenen Kontaktstellen 4 nicht elektrisch kontaktiert werden, so daß eine Mehrfachbelegung der miteinender elektrisch verbundenen Scankanäle 9 einfach vermieden werden kann, wobei gleichzeitig eine hohe Dichte an Kontaktstellen 4 zur Verfügung gestellt wird, die bei lokalen Ansammlungen von Leiterplattentestpunkten auf der zu prüfenden Leiterplatte von Vorteil ist.

Die erfindungsgemäße Vorrichtung kann z.B. zum Prüfen von sogenannten Backplanes mit einer Größe von 1000 mm x 600 mm ausgelegt sein. Solche Backplanes besitzen z.B. etwa 20.000 Leiterplattentestpunkte, die mit der Prüfvorrichtung kontaktiert werden müssen. Übliche Testgeräte weisen ein Raster von 1/10 Zoll (inch) auf, so daß herkömmliche Testgeräte ein Grundraster mit 160.000 Kontaktstellen aufweisen, wobei jede Kontaktstelle einzeln mit der Prüfelektronik verbunden ist. Diese Prüfvorrichtungen weisen deshalb eine Prüfelektronik für 160.000 Kontaktstellen auf, wobei eine entsprechend große Anzahl an Elektronikkarten vorzusehen ist. Durch die erfindungsgemäße Verknüpfung der Kontaktstellen 4 im Prüffeldbereich sind eine Vielzahl von Kontaktstellen gemeinsam mit jeweils einem einzigen Eingang der Prüfelektronik verbunden. Hierdurch kann die Anzahl an Elektronikkarten drastisch verringert werden und dennoch alle mit der zu prüfenden Leiterplatte in Kontakt stehenden Kontaktstellen 4 der Prüfvorrichtung ordnungsgemäß angesteuert werden.

Mit der erfindungsgemäßen Ausgestaltung einer Prüfvorrichtung ist es auch möglich, derart große Prüffeldbereiche mit erhöhter Kontaktstellendichte, z.B. doppelter Kontaktstellendichte zu versehen, wobei die eingesetzte Elektronik nicht erhöht werden muß. Eine solche Erhöhung der Kontaktdichte ist zweckmäßig, wenn an der Leiterplatte Kontaktstellenbereiche mit hoher lokaler Dichte vorgesehen sind, wie sie z.B. für moderne, hochintegrierte ICs notwendig sind.

Ein weiterer Vorteil der Erfindung liegt darin, daß man mit einer einzigen Grundrasterplatte 2 durch Variieren der Anordnung der Kontaktstifte 17 im Busadapter 14 die elektrischen Verbindungen zwischen den Scankanälen 9 verändern kann. Hierdurch kann man an einer einzigen Grundrasterplatte 2 unterschiedliche Verknüpfungen der Kontaktstellen 4 im Prüffeldbereich 11 erzeugen und individuell an die zu prüfende Leiterplatte anpassen.

Die Erfindung ist nicht auf obiges Ausführungsbeispiel beschränkt; im Rahmen der Erfindung liegt z.B. auch eine Ausführungsform, bei der die Elektronikkarten an der Busplatte angeschlossen sind, wobei bspw. der Busadapter und die Busplatte unterhalb der Grundrasterplatte angeordnet sind. Es ist auch möglich, daß die Busplatte mit Steckstiften versehen ist, die direkt in die hohlen, ohne Abdeckung ausgebildeten Durchkontaktierungen des Anschlußbereichs 12 eingesteckt werden können. Bei einer solchen Ausführungsform wird kein Adapter benötigt, da die Busplatte unmittelbar mit der Grundrasterplatte verbunden wird. Es sind jedoch auch beliebige andere Verbindungstechniken möglich zum selektiven elektrischen Verbinden der Scankanäle. Der Busadapter kann z.B. auch als Gummiadapter ausgebildet sein. Ein solcher Gummiadapter ist eine elastische Gummiplatte mit elektrisch leitenden Abschnitten, die die Scankanäle mit den Busleitungen elektrisch verbinden.

## Patentansprüche

1. Vorrichtung zum Prüfen von unbestückten Leiterplatten, insbesondere großflächigen, unbestückten Leiterplatten, mit
einem Grundraster (3), das mit in einem vorbestimmten Raster angeordneten Kontaktstellen (4) versehen ist, wobei jeweils mehrere Kontaktstellen (4) elektrisch mit einem geradlinig verlaufenden Scankanal (9) verbunden sind, und auf dem Grundraster (3) ein Adapter und/oder ein Translator lagert,
einer Auswerteelektronik, die elektrisch mit den Kontaktstellen über die Scankanäle (9) verbunden ist,
eine zu prüfende Leiterplatte auf den Adapter und/oder den Translator derart aufgelegt werden kann, daß der Adapter und/oder Translator einen elektrischen Kontakt von auf der Leiterplatte befindlichen Leiterplattentestpunkten zu Kontaktstellen (4) des Grundrasters (3) herstellt,
**gekennzeichnet durch**
eine Einrichtung zum elektrischen Verbinden von mehreren Scankanälen (9) zu Gruppen von elektrisch miteinander verbundenen Scankanälen, so daß die Scankanäle einer Gruppe lediglich mit einem einzigen Anschluß der Auswerteelektronik verbunden sind.

2. Vorrichtung nach Anspruch 1,
**dadurch gekennzeichnet,**
daß die Einrichtung zum elektrischen Verbinden von zumindest zwei Scankanälen (9) eine Busplatte (15) mit mehreren vorzugsweise parallel verlaufenden Busleitungen (16) aufweist, die selektiv mit den Scankanälen in Verbindung gebracht werden können.

3. Vorrichtung nach Anspruch 2,
**dadurch gekennzeichnet,**
daß zwischen der Busplatte (15) und der das Grundraster (3) aufweisenden Grundrasterplatte (2) ein Busadapter (14) angeordnet ist, mit welchem die Scankanäle (9) selektiv mit den Busleitungen (16) verbunden sind.

4. Vorrichtung nach Anspruch 2,
**dadurch gekennzeichnet,**
daß die Busplatte (15) mit Kontaktelementen, wie z.B. Kontaktstiften, zum direkten Kontaktieren einer die Scankanäle (9) aufweisenden Grundrasterplatte (2) versehen ist.

5. Vorrichtung nach einem der Ansprüche 2 bis 4,
**gekennzeichnet durch**
einen Grundrasterplatte (2) mit
einem Prüffeldbereich (11), in dem die mit den Scankanälen (9) verbundenen Kontaktstellen (4) zum elektrischen Kontaktieren mit einer zu prüfenden Leiterplatte angeordnet sind, und
einem Anschlußbereich (12), in dem weitere mit den Scankanälen verbundene Kontaktstellen (4) zum Kontaktieren der Busleitungen (16) vorgesehen sind.

6. Vorrichtung nach Anspruch 5,
**dadurch gekennzeichnet,**
daß am Anschlußbereich (12) an der den Kontaktstellen (4) zum Kontaktieren der Busleitungen (16) gegenüberliegenden Seite der Grundrasterplatte (2) Kontaktstellen (13) zum Kontaktieren der Auswerteelektronik vorgesehen sind.

7. Vorrichtung nach Anspruch 6,
**dadurch gekennzeichnet,**
daß die Kontaktstellen (4,13) an der Grundrasterplatte (2) paarweise gegenüberligend angeordnet und jeweils mit einem Scankanal (9) verbunden sind.

8. Vorrichtung nach einem der Ansprüche 5 bis 7,
**dadurch gekennzeichnet,**
daß der Prüffeldbereich eine Fläche von zumindest 250.000 mm² aufweist.

9. Vorrichtung nach einem der Ansprüche 1 bis 8,
**dadurch gekennzeichnet,**
daß die Kontaktstelen (4) zum Kontaktieren der zu prüfenden Leiterplatte mit einem Rasterabstand von nicht mehr als 1/10 Zoll (2,54 mm) angeordnet sind.

## Claims

1. Device for testing bare circuit boards, in particular large-area bare circuit boards, with
a basic grid (3) which is provided with contact points (4) arranged in a predetermined grid, wherein a plurality of contact points (4) are electrically connected to each rectilinear scanning channel (9), and an adapter and/or a translator is mounted on the basic grid (3),
an electronic evaluating module which is electrically connected to the contact points via the scanning channels (9),
a circuit board to be tested can be placed onto the adapter and/or the translator in such a way that the adapter and/or translator produces an electrical contact from circuit board test points located on the circuit board to contact points (4) of the basic grid (3),
characterised by
a device for electrically connecting a plurality of scanning channels (9) to groups of scanning channels electrically connected to one another, so the scanning channels of one group are only connected to a single terminal of the electronic evaluating module.

2. Device according to claim 1, characterised in that the device for electrically connecting at least two scanning channels (9) has a bus board (15) with a plurality of bus lines (16), preferably extending in parallel, which can be selectively connected to the scanning channels.

3. Device according to claim 2, characterised in that a bus adapter (14) is arranged between the bus board (15) and the basic grid board (2) comprising the basic grid (3), with which adapter the scanning channels (9) are selectively connected to the bus lines (16).

4. Device according to claim 2, characterised in that the bus board (15) is provided with contact elements, such as contact pins for example, for directly contacting a basic grid board (2) comprising the scanning channels (9).

5. Device according to one of claims 2 to 4, characterised by a basic grid board (2) with a testing station region (11) in which the contact points (4) connected to the scanning channels (9) are arranged so as to electrically contact a circuit board to be tested, and a connection region (12) in which further contact points (4) connected to the scanning channels are provided for contacting the bus lines (16).

6. Device according to claim 5, characterised in that contact points (13) for contacting the electronic evaluating module are provided on the connection region (12), on the side of the basic grid board (2) remote from the contact points (4) for contacting the bus lines (16).

7. Device according. to claim 6, characterised in that the contact points (4, 13) are arranged in opposing pairs on the basic grid board (2) and each opposing pair is connected to a respective scanning channel (9).

8. Device according to one of claims 5 to 7, characterised in that the testing station region has an area of at least 250,000 mm².

9. Device according to one of claims 1 to 8, characterised in that the contact points (4) for contacting the circuit board to be tested are arranged with a grid spacing of not more than 1/10 inch (2.54 mm).

## Revendications

1. Dispositif pour tester des cartes de circuits imprimés nues, en particulier des cartes de circuits imprimés nues de grande surface, comportant
une grille de base (3) qui est dotée de lieux de contact agencés suivant une trame prédéterminée, chaque lieu de contact d'une pluralité de lieux de contact (4) étant raccordé électriquement à un canal de balayage rectiligne (9) et un adaptateur et/ou convertisseur étant monté sur la grille de base (3),
une électronique de traitement qui est connectée électriquement aux lieux de contact par les canaux de balayage (9),
une carte de circuits imprimés à tester peut être placée sur l'adaptateur et/ou le convertisseur de telle façon que l'adaptateur et/ou le convertisseur réalise un contact électrique des points de test se trouvant sur la carte de circuits imprimés avec les lieux de contact (4) de la grille de base (3),
caractérisé par
un dispositif pour le raccordement électrique de plusieurs canaux de balayage (9) à des groupes de canaux de balayage connectés électriquement entre eux de sorte que les canaux de balayage d'un groupe soient purement et simplement connectés à une seule borne de connexion de l'électronique de traitement.

2. Dispositif selon la revendication 1, caractérisé en ce que le dispositif pour la connexion électrique d'au moins deux canaux de balayage (9) comporte une carte de bus (15) dotée de plusieurs lignes de bus (16) s'étendant de préférence en parallèle, qui peuvent être mises sélectivement en contact avec les canaux de balayage.

3. Dispositif selon la revendication 2, caractérisé en ce que, entre la carte de bus (15) et la carte (2) comportant la grille de base (3), est agencé un adaptateur de bus (14) au moyen duquel les canaux de balayage (9) sont sélectivement connectés aux lignes de bus (16).

4. Dispositif selon la revendication 2, caractérisé en ce que la carte de bus (15) est dotée d'éléments de contact, comme par exemple des bornes de contact, pour le contact direct avec une carte (2), dotée d'une grille de base, qui comporte les canaux de balayage (9).

5. Dispositif selon l'une des revendications 2 à 4, caractérisé par une carte (2), dotée
d'une grille de base, qui comporte
une zone de test (11) dans laquelle sont agencés les lieux de contact (4) connectés aux canaux de balayage (9) pour réaliser le contact électrique avec une carte de circuits imprimés à tester, et
une zone de connexion (12) dans laquelle il est prévu des lieux de contact supplémentaires (4) connectés aux canaux de balayage pour réaliser le contact avec les lignes de bus (16).

6. Dispositif selon la revendication 5, caractérisé en ce qu'il est prévu des lieux de contact (13) pour le contact avec l'électronique de traitement au niveau de la zone de connexion (12) du côté de la carte (2), dotée d'une grille de base, qui est opposé aux lieux de contact (4) pour le contact avec les lignes de bus (16).

7. Dispositif selon la revendication 6, caractérisé en ce que les lieux de contact (4, 13) sont agencés par paire les uns en face des autres sur la carte (2), dotée d'une grille de base, chacun d'eux étant connecté à un canal de balayage (9).

8. Dispositif selon l'une des revendications 5 à 7, caractérisé en ce que la zone de test a une surface d'au moins 250 000 mm².

9. Dispositif selon l'une des revendications 1 à 8, caractérisé en ce que les lieux de contact (4) pour le contact avec la carte de circuits imprimés à tester sont agencés avec une définition de trame ne dépassant pas 1/10 de pouce (2,54 mm).
